# EUROPEAN PATENT APPLICATION

(11) **EP 4 708 351 A1**
(43) Date of publication of application: **11.03.2026**
(21) Application number: 25187964.9
(22) Date of filing: 07.07.2025
(51) Int. Cl.: H01J 37/32, C23C 14/56

(54) **METHOD FOR CLEANING SPUTTERING APPARATUS, SPUTTERING METHOD INCLUDING THE SAME, AND SPUTTERING SYSTEM**

(30) Priority: 16.07.2024 KR 20240093610
(71) Applicant: Samsung Display Co., Ltd., Yongin-si, Gyeonggi-do (KR)
(72) Inventor: JO, Soo Beom, Yongin-si (KR); SHIN, Hyuneok, Yongin-si (KR); LEE, You Jong, Yongin-si (KR); HUH, Myungsoo, Yongin-si (KR)
(74) Representative: Marks & Clerk LLP

(57) **Abstract**

A method for cleaning a sputtering apparatus includes removing a portion of a first material deposited in the sputtering apparatus, and oxidizing a remaining portion of the first material deposited in the sputtering apparatus after the removing the portion of the first material deposited in the sputtering apparatus. The sputtering apparatus includes a process chamber which provides a process space, a stage within the process space, a discharge tube which provides a plasma discharge space extended to the process space, and a radio frequency ("RF") coil which wraps the discharge tube. The oxidizing the remaining portion of the first material deposited in the sputtering apparatus includes supplying an oxygen gas to the plasma discharge space.

## Description

### BACKGROUND

### 1. Field

The disclosure herein relates to a method for cleaning a sputtering apparatus, a sputtering method including the same, and a sputtering system.

### 2. Description of the Related Art

Electronic apparatuses such as smart phones, digital cameras, laptop computers, navigation units, and smart televisions, which provide an image to a user, include a display apparatus for displaying the image.

The display apparatus generates an image and provides the generated image to the user through a display screen. The display apparatus may be made through various processes. For example, the display apparatus may be manufactured through processes such as etching, deposition, and cleaning with respect to the substrate. The etching process on the substrate may be a process of removing a portion of materials in the substrate. For this purpose, a wet etching process and/or a dry etching process may be used.

### SUMMARY

The disclosure provides a method for cleaning a sputtering apparatus, which may be capable of removing a redeposited material in a process chamber, a sputtering method including the same, and a sputtering system.

Embodiments of the disclosure also provides a method for cleaning a sputtering apparatus, which may prevent subsequent processes from being interrupted by redeposited material in the process chamber, a sputtering method including the same, and a sputtering system.

An embodiment of the inventive concept provides a method for cleaning a sputtering apparatus including, removing a portion of a first material deposited in the sputtering apparatus, and oxidizing a remaining portion of the first material deposited in the sputtering apparatus after the removing the portion of the first material deposited in the sputtering apparatus, where the sputtering apparatus includes: a process chamber which provides a process space; a stage within the process space; a discharge tube which provides a plasma discharge space extended to the process space; and a radio frequency ("RF") coil which wraps the discharge tube, and wherein oxidizing the remaining portion of the first material deposited in the sputtering apparatus includes supplying an oxygen gas to the plasma discharge space.

There is further provided a sputtering method comprising, etching a substrate using a sputtering apparatus, removing the substrate from the sputtering apparatus, and cleaning the sputtering apparatus from which the substrate is removed, wherein the sputtering apparatus comprises: a process chamber which provides a process space, a stage within the process space, a discharge tube which provides a plasma discharge space extended to the process space, and a radio frequency coil which wraps the discharge tube, wherein the cleaning the sputtering apparatus comprises supplying an oxygen gas into the sputtering apparatus to oxidize a first material deposited in the sputtering apparatus.

In an embodiment of the inventive concept, a sputtering system includes: a sputtering apparatus; a process gas supply device which supplies a process gas to the sputtering apparatus; and an oxygen gas supply device which supplies an oxygen gas to the sputtering apparatus, where the sputtering apparatus includes: a process chamber which provides a process space; a stage within the process space; a discharge tube which provides a plasma discharge space extended to the process space; an RF coil which wraps the discharge tube; and a heating device which heats the discharge tube.

At least some of the above and other features of the invention are set out in the claims.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a cross-sectional view of an embodiment of a sputtering system according to the inventive concept;
FIG. 2 is an enlarged cross-sectional view of area X of FIG. 1;
FIG. 3 is a flowchart illustrating an embodiment of a sputtering method according to the inventive concept;
FIG. 4 is a flowchart illustrating an embodiment of a sputtering apparatus cleaning method according to the inventive concept; and
FIGS. 5 and 12 are cross-sectional views sequentially illustrating the sputtering method according to the flowchart of FIG. 3.

### DETAILED DESCRIPTION

In this specification, it will also be understood that when one component (or region, layer, portion) is also referred to as being 'on', 'connected to', or 'coupled to' another component, it may be directly disposed/connected/coupled on/to the one component, or an intervening third component may also be present.

Like numbers refer to like elements throughout. Also, in the drawing figures, the thickness, ratio, and dimensions of components are exaggerated for clarity of illustration. The term "and/or" includes any and all combinations of one or more of the associated listed items.

Although the terms "first," "second," etc. may be used herein to describe various elements, these elements should not be limited by these terms. The terms are only used to distinguish one component from other components. For example, a first element referred to as a first element in an embodiment may be referred to as a second element in another embodiment without departing from the scope of the appended claims. The singular forms include the plural forms as well, unless the context clearly indicates otherwise.

Also, "under", "below", "above', "upper", and the like are used for explaining relation association of components illustrated in the drawings. These terms are used as a spatially relative concept and are described based on the directions indicated in the drawings.

It will be understood that the term "include" or "comprise", when used in this specification, specifies the presence of stated features, integers, steps, operations, elements, components, or a combination thereof, but does not preclude the presence or addition of one or more other features, integers, steps, operations, elements, components, or combinations thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which the disclosure belongs. In addition, terms such as those defined in commonly used dictionaries should be interpreted as having meanings consistent with their meanings in the context of the relevant technology, and unless explicitly defined, it should not be interpreted in an overly idealistic or overly formal sense.

Hereinafter, a method for cleaning a sputtering apparatus (hereinafter, also referred to as a "sputtering apparatus cleaning method"), a sputtering method including the same, and a sputtering system in an embodiment of the inventive concept will be described with reference to the accompanying drawings.

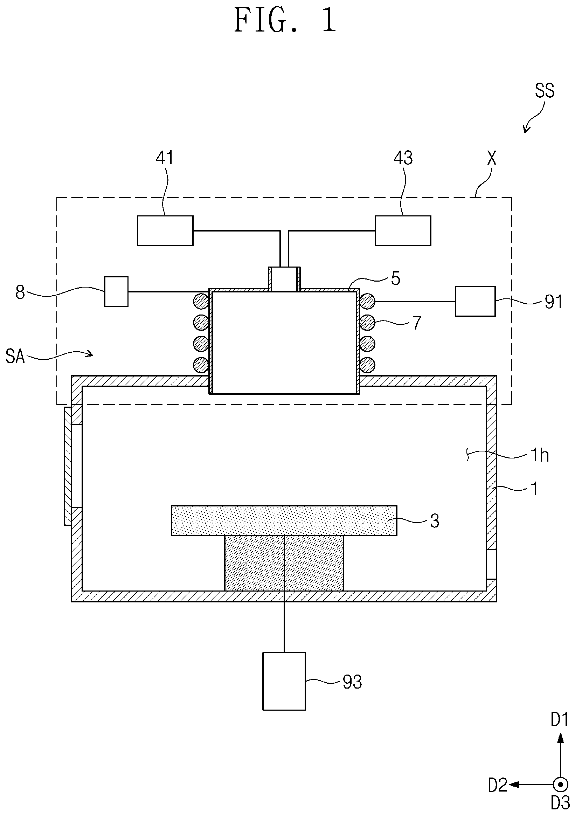

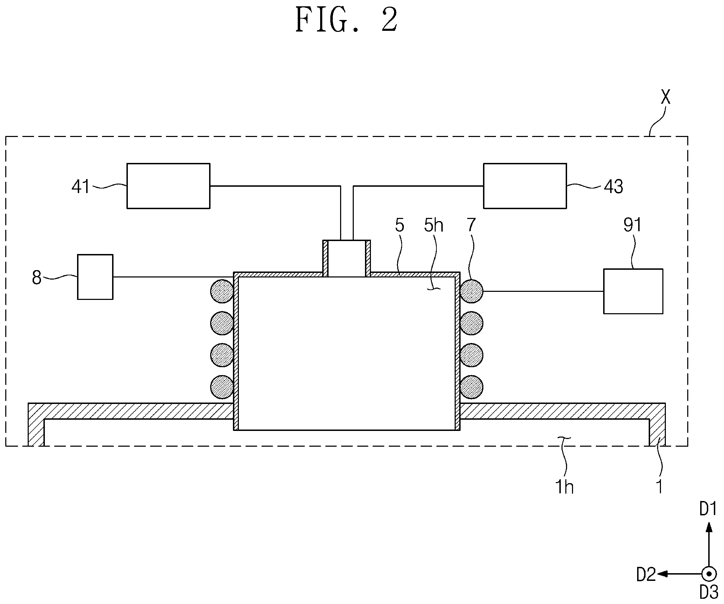

FIG. 1 is a cross-sectional view of an embodiment of a sputtering system in an embodiment of the inventive concept, and FIG. 2 is an enlarged cross-sectional view of area X of FIG. 1.

Hereinafter, a reference character D1 may be referred to as a first direction, a reference character D2 crossing the first direction D1 may be referred to as a second direction, and a reference character D3 crossing both the first direction D1 and the second direction D2 may be referred to as a third direction. The first direction D1 may be referred to as a vertical direction. Also, each of the second direction D2 and the third direction D3 may be referred to as a horizontal direction.

Referring to FIGS. 1 and 2, a sputtering system SS may be provided.

The sputtering system SS may be a system that performs a dry etching process on a substrate. In an embodiment, a sputtering system SS may perform a sputtering process for etching a portion of a copper in the substrate to manufacture a display apparatus, for example. For this purpose, the sputtering system SS may include a sputtering apparatus SA, a process gas supply device 41, an oxygen gas supply device 43, a radio frequency ("RF") power application device 91, and a bias power application device 93.

The sputtering apparatus SA can perform a sputtering process on the substrate. For this purpose, the sputtering apparatus SA includes a process chamber 1, a stage 3, a discharge tube 5, an RF coil 7, and a heating device 8.

The process chamber 1 provides a process space 1h. The process space 1h may be separated from an external space by the process chamber 1. The process space 1h may have a quadrangular, e.g., rectangular parallelepiped shape or a cylindrical shape. Within the process space 1h, an etching process can be performed on the substrate. During the etching process on the substrate, the process space 1h may be maintained in a substantially vacuum state. For this, a vacuum pump (not shown) may be connected to the process space 1h. However, the disclosure is not limited thereto.

The stage 3 is disposed inside the process space 1h. The stage 3 may support the substrate. That is, the etching process on the substrate may be performed in a state in which the substrate is disposed on the stage 3. The stage 3 may have various structures to fix the substrate. In an embodiment, stage 3 may include an electrostatic chuck ("ESC") that fixes the substrate in a predetermined position using electrostatic force. However, it is not limited thereto, and the stage 3 may also include a vacuum chuck and/or a clamp chuck, etc.

The discharge tube 5 provides a plasma discharge space 5h. The discharge tube 5 may be coupled to an upper portion of the process chamber 1. The plasma discharge space 5h extends to the process space 1h. The plasma discharge space 5h may have a cylindrical shape, but it is not limited thereto. Plasma may be generated within the plasma discharge space 5h. This will be described later in detail.

The RF coil 7 wraps the discharge tube 5. More particularly, the RF coil 7 may wrap around an outer surface of the discharge tube 5. The RF coil 7 may wrap around the discharge tube 5 multiple times. The RF coil 7 may include a conductive material. The RF coil 7 may be electrically connected to the RF power application device 91. An electric field and/or a magnetic field may be generated within the plasma discharge space 5h by the RF coil 7. The plasma may be generated in the plasma discharge space 5h by the RF coil 7. This will be described later in detail.

The heating device 8 that heats the discharge tube 5. A temperature of the plasma discharge space 5h may be increased by the heating device 8. For this, the heating device 8 may be connected to the discharge tube 5. The heating device 8 may have various structures capable of raising the temperature of the discharge tube 5. In an embodiment, the heating device 8 may include an infrared ("IR") heating device. The IR heating device may irradiate IR to the plasma discharge space 5h. In an alternative embodiment, the heating device 8 may include a heating module. The heating module may be connected to one end of the discharge tube 5. The discharge tube 5 may be heated by the heating module. In an alternative embodiment, the heating device 8 may include a heating line. The heating line may be coupled to the discharge tube 5. The discharge tube 5 may be heated by the heating line. However, it is not limited thereto, and the heating device 8 may have other structures for heating the discharge tube 5. The heating device 8 will be described later in detail.

The process gas supply device 41 supplies a process gas to the sputtering apparatus SA. In an embodiment, the process gas supply device 41 may supply an argon (Ar) gas to the sputtering apparatus SA, for example. However, it is not limited thereto, and the process gas supply device 41 may supply other types of process gases as well. The process gas supply device 41 may be connected to the sputtering apparatus SA. The process gas supply device 41 may include a process gas tank, a compressor, a valve, and/or a piping, etc. At least one portion of the process gas supplied from the process gas supply device 41 may be converted into plasma in the plasma discharge space 5h. This will be described later in detail.

The oxygen gas supply device 43 may supply an oxygen gas to the sputtering apparatus SA. In an embodiment, the oxygen gas supply device 43 may supply oxygen gas to the sputtering apparatus SA to oxidize a predetermined material within the sputtering apparatus SA, for example. The oxygen gas supply device 43 may be connected to the sputtering apparatus SA. The oxygen gas supply device 43 may include an oxygen gas tank, a compressor, a valve, and/or a piping, etc. This will be described later in detail.

The RF power application device 91 may apply RF power to the RF coil 7. For this, the RF power application device 91 may be electrically connected to the RF coil 7. The frequency of the RF power applied by the RF power application device 91 to the RF coil 7 may be about 13.56 megahertz (MHz). In an alternative embodiment, the frequency of the RF power applied by the RF power application device 91 to the RF coil 7 may be about 0.5MHz to about 10.0MHz. By the RF power applied to the RF coil 7, an electric field and/or magnetic field may be generated in the plasma discharge space 5h.

The bias power application device 93 may apply bias power to the stage 3. The etching process on the substrate on the stage 3 may be controlled by the bias power, which is applied from the bias power application device 93 to the stage 3. This will be described later in detail.

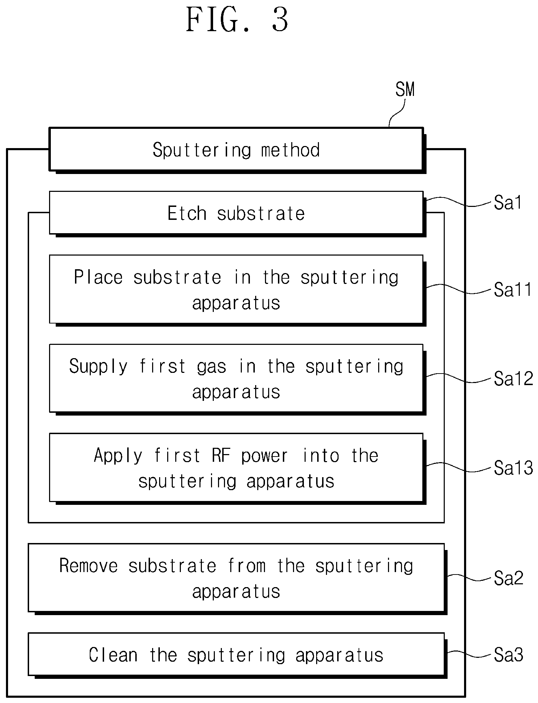

FIG. 3 is a flowchart illustrating an embodiment of a sputtering method according to the inventive concept.

Referring to FIG. 3, a sputtering method SM is provided. The sputtering method SM is a method for performing an etching process on a substrate and may use the sputtering system SS described with reference to FIGS. 1 and 2. The sputtering method SM includes etching the substrate (operation Sa1), removing the substrate from the sputtering apparatus (operation Sa2), and cleaning the sputtering apparatus (operation Sa3).

The etching of the substrate (operation Sa1) may include placing the substrate in the sputtering apparatus (operation Sa11), supplying a first gas into the sputtering apparatus (operation Sa12), and applying a first RF power to the sputtering apparatus (operation Sa13).

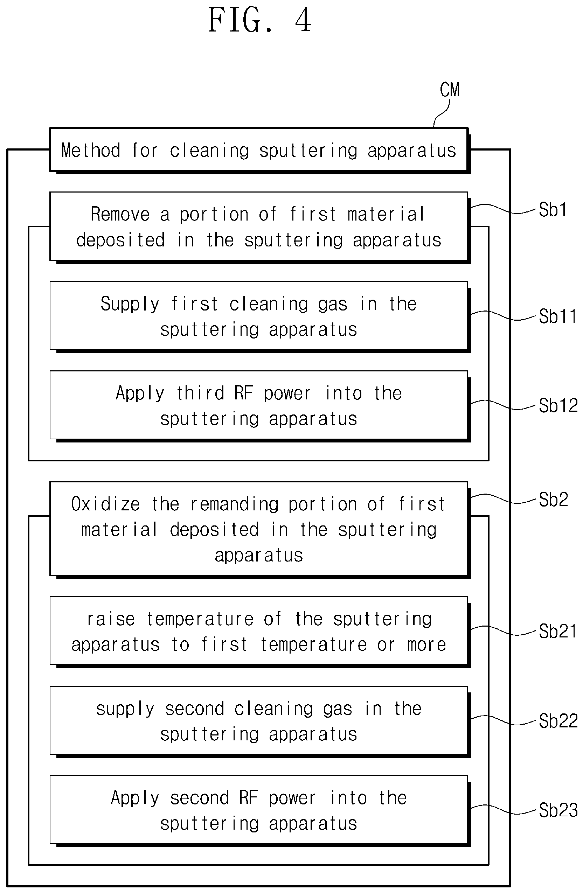

FIG. 4 is a flowchart illustrating an embodiment of a method for cleaning the sputtering apparatus according to the inventive concept.

Referring to FIG. 4, a sputtering apparatus cleaning method CM is provided. The sputtering apparatus cleaning method CM is a method for cleaning a sputtering apparatus such as the sputtering apparatus SA described with reference to FIG. 1 and FIG. 2. That is, the sputtering apparatus cleaning method CM may be a method of performing the cleaning of the sputtering apparatus (operation Sa3) as described with reference to FIG. 3. The sputtering apparatus cleaning method CM includes removing a portion of the first material deposited in the sputtering apparatus (operation Sb1) and oxidizing the remaining portion of the first material deposited in the sputtering apparatus (operation Sb2).

The removing a portion of the first material deposited in the sputtering apparatus (operation Sb1) may include supplying a first cleaning gas into the sputtering apparatus (operation Sb11) and applying a third RF power to the sputtering apparatus (operation Sb12).

The oxidizing of the remaining portion of the first material deposited in the sputtering apparatus (operation Sb2) may include raising a temperature of the sputtering apparatus to a first temperature or more (operation Sb21). The oxidizing of the remaining portion of the first material deposited in the sputtering apparatus (operation Sb2) includes supplying a second cleaning gas into the sputtering apparatus (operation Sb22), and may include applying a second RF power to the sputtering apparatus (operation Sb23).

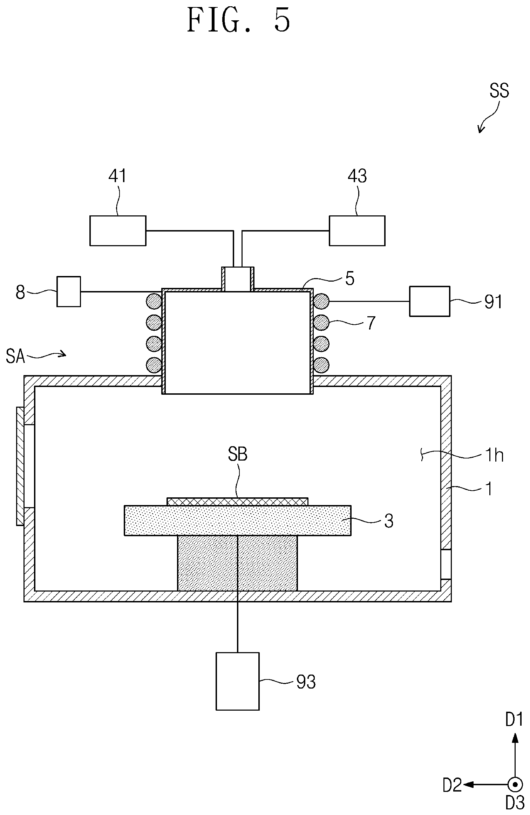

Hereinafter, with reference to FIGS. 5 to 12, the sputtering method SM of FIG. 3 and the sputtering apparatus cleaning method CM of FIG. 4 will be described in detail.

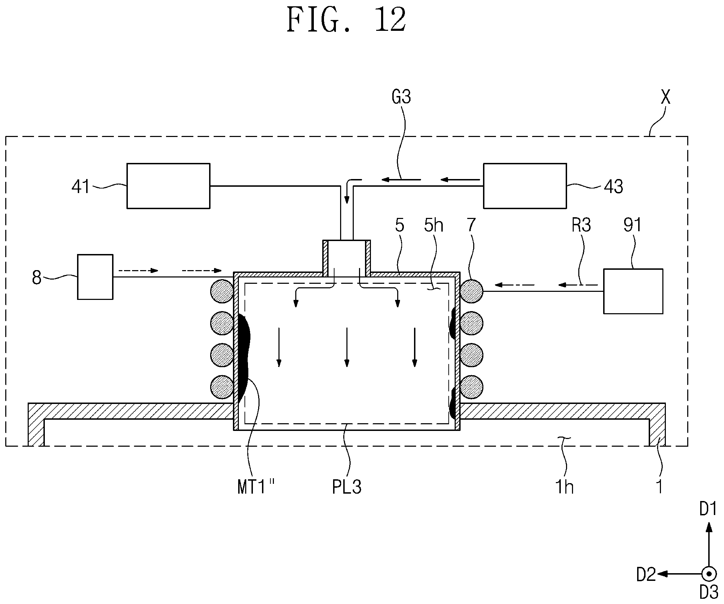

FIGS. 5 and 12 are cross-sectional views sequentially illustrating the sputtering method according to the flowchart of FIG. 3.

Referring to FIGS. 5 and 3, the placing Sa11 of the substrate in the sputtering apparatus may include placing the substrate SB on the stage 3. The stage 3 may fix the substrate SB at a predetermined position on the stage 3. However, it is not limited thereto, and the substrate SB may be disposed on a top surface of the stage 3 without any separate fixing force.

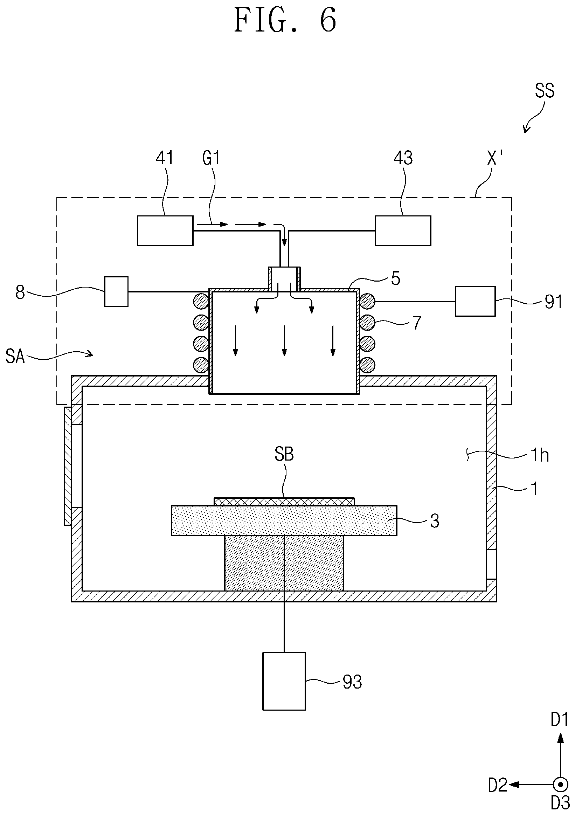

Referring to FIGS. 6 and FIG. 3, the supplying of the first gas into the sputtering apparatus (operation Sa12) may include a process in which the process gas supply device 41 supplies a first gas G1 into the plasma discharge space 5h. The first gas G1 may be a process gas for etching the substrate SB. In an embodiment, the first gas G1 may include argon (Ar) gas, for example, but it is not limited thereto.

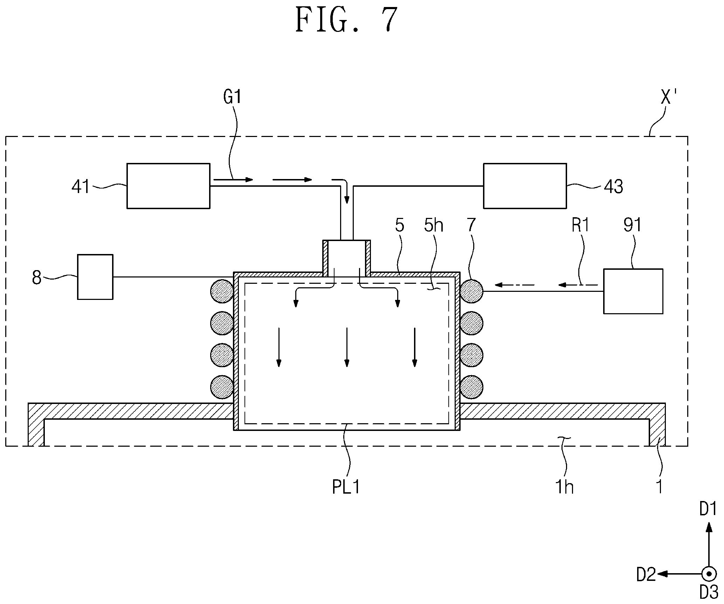

Referring to FIGS. 7 and 3, the applying of the first RF power to the sputtering apparatus (operation Sa13) may include a process in which the RF power application device 91 applies a first RF power R1 to the RF coil 7. The first RF power R1 may be about 13.56MHz, but it is not limited thereto. By the first RF power R1 applied to the RF coil 7, an electric field and/or a magnetic field may be generated in the plasma discharge space 5h. Accordingly, at least one portion of the first gas (also referred to as a first process gas) G1 within the plasma discharge space 5h may be converted into plasma PL1.

Referring back to FIG. 3, the etching of the substrate (operation Sa1) may further include applying bias power to the stage. In other words, as shown area X' in FIG. 6, bias power may be supplied from the bias power supply device 93 to the stage 3. Accordingly, the plasma PL1 within the plasma discharge space 5h may be controlled. In an embodiment, the plasma PL1 may move toward the substrate SB, for example. Thus, the substrate SB on the stage 3 may be sputtered. The material sputtered from the substrate SB may be copper (Cu), for example. That is, the sputtering method SM (refer to FIG. 3) according to the inventive concept may mean a copper (Cu) etching process that etches copper (Cu) from the substrate SB.

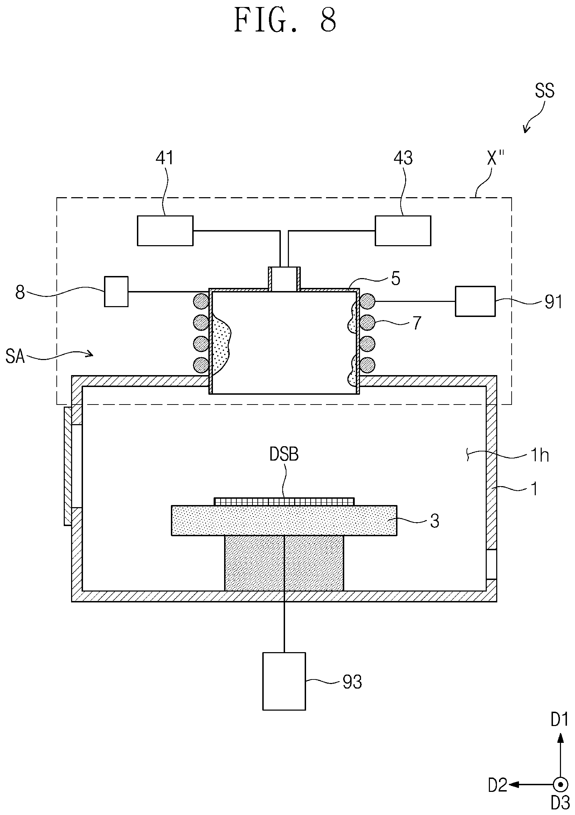

Referring to area X'' in FIG. 8 with FIG. 3, the removing of the substrate from the sputtering apparatus (operation Sa2) may include removing the sputtered substrate SB (refer to FIG. 6) from the stage 3. The sputtered substrate SB may exit to the outside of the process chamber 1.

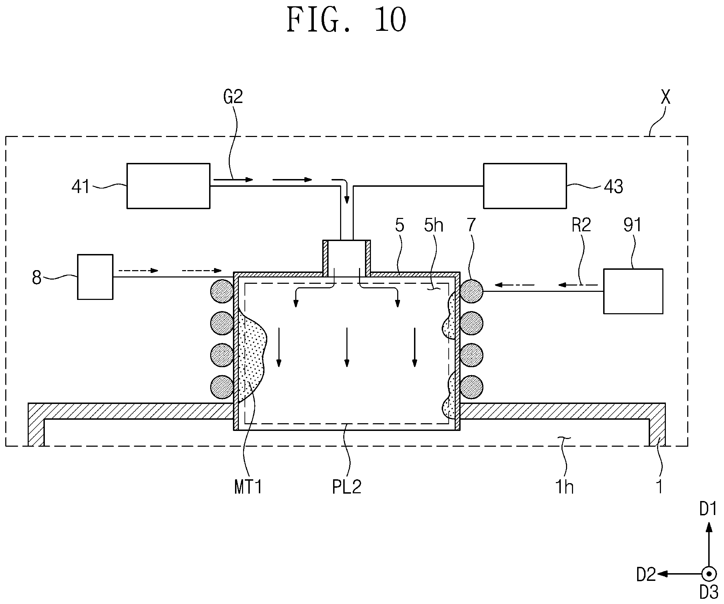

Referring back to FIG. 3, the cleaning of the sputtering apparatus (operation Sa3) may further include placing a dummy substrate DSB on the stage 3 from which the sputtered substrate SB is removed. In other words, after the sputtered substrate SB exits the process chamber 1, the dummy substrate DSB may be disposed on the stage 3 before supplying a first cleaning gas G2 (refer to FIG. 10) into the sputtering apparatus SA. As a result, the stage 3 may be protected. However, it is not limited thereto, and cleaning the sputtering apparatus (operation Sa3) in a state in which the dummy substrate DSB is not disposed on the stage 3 may be performed.

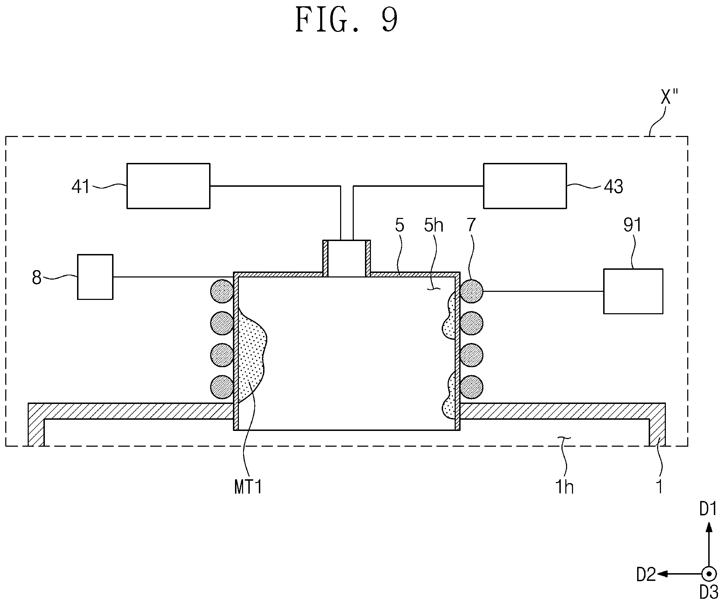

Referring to area X'' in FIG. 9, a first material MT1 may be deposited in the sputtering apparatus SA. More particularly, in the etching of the substrate (refer to operation Sa1 of FIG. 3), the first material MT1 sputtered from the substrate SB (refer to FIG. 6) may be redeposited on an inner surface of the discharge tube 5. The first material MT1 may include copper (Cu), for example. A process on the substrate may be interrupted by the first material MT1 redeposited in the discharge tube 5. In an embodiment, even when the RF power is applied to the RF coil 7, the generation of an electric field and/or magnetic field in the plasma discharge space 5h may be interrupted by the first material MT1, which is a conductive material, for example.

Although it has been illustrated and described based on the redeposition of the first material MT1 inside the discharge tube 5, the first material MT1 may be redeposited in a location other than the discharge tube 5. In an embodiment, the first material MT1 may be deposited on an inner surface of the process chamber 1, for example.

Referring to FIGS. 10 and 4, the supplying of the first cleaning gas into the sputtering apparatus (operation Sb11) may include a process in which the process gas supply device 41 supplies the first cleaning gas G2 to the plasma discharge space 5h. The first cleaning gas G2 may be a gas for removing the redeposited first material MT1. In an embodiment, the first cleaning gas G2 may include argon (Ar) gas, for example, but it is not limited thereto.

The applying of the third RF power to the sputtering apparatus (operation Sb12) may include a process in which the RF power application device 91 applies the third RF power R2 to the RF coil 7. The third RF power R2 may be weaker than the first RF power R1 (refer to area X' in FIG. 7). In an embodiment, the frequency of the third RF power R2 may be about 0.5MHz to about 10.0MHz, for example. However, it is not limited thereto, and the frequency of the third RF power R2 may be different. In an alternative embodiment, the frequency of the third RF power R2 may be substantially the same as or similar to that of the first RF power R1. By the third RF power R2 applied to the RF coil 7, at least one portion of the first cleaning gas G2 disposed in the plasma discharge space 5h may be converted into plasma PL2. By the plasma PL2 in the plasma discharge space 5h, a portion of the first material MT1 may be removed. This will be described later in detail.

Referring back to FIG. 4, in the removing of a portion of the first material deposited in the sputtering apparatus (operation Sb1), bias power need not be applied to the stage 3. However, it is not limited thereto, and in the removing of a portion of the first material deposited in the sputtering apparatus (operation Sb1), bias power may be applied to the stage 3.

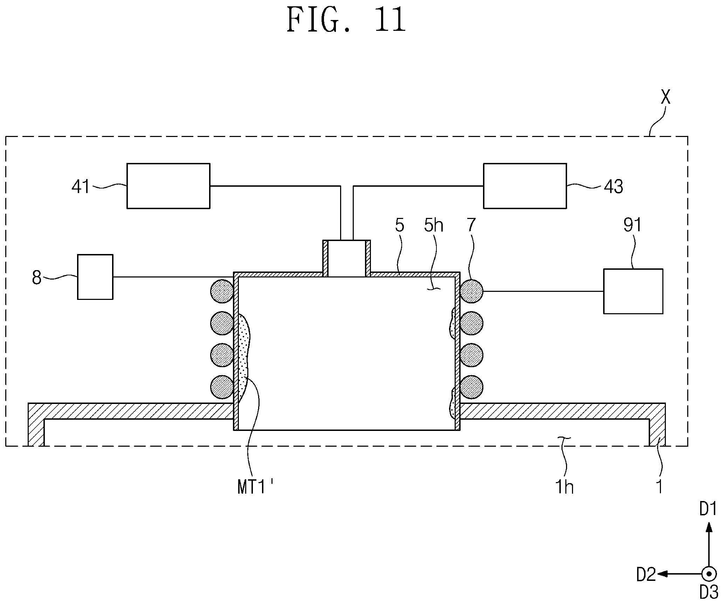

Referring to FIG. 11, due to the plasma PL2 (refer to FIG. 10) within the plasma discharge space 5h, a portion of the first material MT1 may be sputtered and fall off from an inner surface of the discharge tube 5. Accordingly, the amount of the first material MT1 redeposited on the inner surface of the discharge tube 5 may be reduced.

Referring to FIGS. 12 and 4, the raising of the temperature of the sputtering apparatus to the first temperature or more (operation Sb21) may include a process in which the heating device 8 heats the discharge tube 5. Therefore, a temperature of the discharge tube 5 in the oxidizing of the first material deposited in the sputtering apparatus may be higher than that of the discharge tube 5 in the etching of the substrate using the sputtering apparatus. By the heating device 8, the temperature of the plasma discharge space 5h may be heated to the first temperature or more. The first temperature may be about 120 degrees Celsius (°C) to about 180°C, for example, but it is not limited thereto.

Although it is illustrated and described that the heating device 8 heats the discharge tube 5 in the process of oxidizing the remaining portion of the first material deposited in the sputtering apparatus (operation Sb2), the heating of the discharge tube 5 may be performed in the removing of a portion of the first material deposited in the sputtering apparatus (operation Sb1). That is, the discharge tube 5 may be heated by the heating device 8 in the removing of a portion of the first material deposited in the sputtering apparatus (operation Sb1) before performing the supplying of the first cleaning gas into the sputtering apparatus (operation Sb11).

The supplying of a second cleaning gas into the sputtering apparatus (operation Sb22) may include a process in which the oxygen gas supply device 43 supplies a second cleaning gas G3 to the plasma discharge space 5h. The second cleaning gas G3 may be a gas for oxidizing a redeposited first material MT1'. In an embodiment, the second cleaning gas G3 may include oxygen gas, for example, but it is not limited thereto.

The applying of the second RF power to the sputtering apparatus (operation Sb23) may include a process in which the RF power application device 91 applies a second RF power R3 to the RF coil 7. The second RF power R3 may be weaker than the first RF power R1 (refer to FIG. 7). In an embodiment, the frequency of the second RF power R3 may be about 0.5MHz to about 10.0MHz, for example. However, it is not limited thereto, and the frequency of the second RF power R3 may be different. In an alternative embodiment, the frequency of the second RF power R3 may be substantially the same as or similar to that of the first RF power R1, for example. By the second RF power R3 applied to the RF coil 7, at least one portion of the second cleaning gas G3 disposed within the plasma discharge space 5h may be converted into plasma PL3. The remaining portion of the first material MT1' may be oxidized by the plasma PL3 within the plasma discharge space 5h. The oxidized first material MT1'' may be non-conductive. Therefore, due to the RF power applied to the RF coil 7, an electric field and/or magnetic field may be smoothly generated in the plasma discharge space 5h. As a result, the etching process on the subsequent substrate may proceed smoothly.

Referring back to FIG. 4, in the oxidizing of the remaining portion of the first material deposited in the sputtering apparatus (operation Sb2), the bias power need not be applied to the stage 3. However, it is not limited thereto, and in the oxidizing of the remaining portion of the first material deposited in the sputtering apparatus (operation Sb2), the bias power may be applied to the stage 3.

According to the sputtering apparatus cleaning method, the sputtering method, and the sputtering system including the same in the embodiments of the inventive concept, the amount of redeposited copper (Cu) in the process chamber and/or the discharge tube may be reduced using plasma. Additionally, the redeposited copper (Cu) in the process chamber and/or the discharge tube may be oxidized by the oxygen gas. Thus, the etching process for subsequent substrates may be prevented from being interrupted by the redeposited copper (Cu) in the process chamber and/or discharge tube. Additionally, without the need to open the process chamber, the process chamber and/or the discharge tube may be cleaned using the first cleaning gas and/or the second cleaning gas. Therefore, the total process may be quickly performed.

According to the sputtering apparatus cleaning method, sputtering method, and sputtering system including the same in the embodiments of the inventive concept, the remaining copper (Cu) may be oxidized by the second cleaning gas after reducing the amount of copper (Cu) to a predetermined level or below using a first cleaning gas, thereby smoothly oxidizing the entirety of the remaining copper (Cu).

According to the sputtering apparatus cleaning method, the sputtering method including this, and the sputtering system in the embodiments of the inventive concept, the RF power applied to the RF coil when supplying the first cleaning gas and/or the second cleaning gas may be weaker than the RF power applied to the RF coil during the etching process on the substrate. In other words, since the optimized RF power is applied for each process, energy may be saved.

According to the sputtering apparatus cleaning method, the sputtering method including it, and the sputtering system in the embodiments of the inventive concept, the sputtering apparatus may be cleaned without opening the process chamber, allowing the dry etching process for copper to be carried out quickly and inexpensively.

According to the sputtering apparatus cleaning method, the sputtering method and the sputtering system including the same in the embodiment of the inventive concept, it is possible to remove the redeposited material in the process chamber.

According to the sputtering apparatus cleaning method, the sputtering method and the sputtering system including the same in the embodiment of the inventive concept, it is possible to prevent subsequent processes from being interrupted by the redeposited material in the process chamber.

Although the embodiments of the invention have been described, it is understood that the invention should not be limited to these embodiments but various changes and modifications may be made by one ordinary skilled in the art within the scope of the invention as hereinafter claimed.

Hence, the technical scope of the inventive concept is to be determined by the following claims, and should not be limited by the foregoing description.

## Claims

1. A method for cleaning a sputtering apparatus, the method comprising:
removing a portion of a first material deposited in the sputtering apparatus (SA); and
oxidizing a remaining portion of the first material deposited in the sputtering apparatus after the removing the portion of the first material deposited in the sputtering apparatus,
wherein the sputtering apparatus (SA) comprises:
a process chamber (1) which provides a process space (1h);
a stage (3) within the process space;
a discharge tube (5) which provides a plasma discharge space (5h) extended to the process space; and
a radio frequency coil (7) which wraps the discharge tube,
wherein the oxidizing the remaining portion of the first material deposited in the sputtering apparatus (SA) comprises supplying an oxygen gas to the plasma discharge space (5h).

2. The method of claim 1, wherein the oxidizing the remaining portion of the first material deposited in the sputtering apparatus (SA) further comprises raising a temperature of the discharge tube to a first temperature or more, optionally wherein the first temperature is about 120 degrees Celsius to about 180 degrees Celsius.

3. The method of claim 1 or 2, wherein the first material comprises copper.

4. The method of claim 1, 2 or 3, wherein oxidizing the remaining portion of the first material deposited in the sputtering apparatus (SA) further comprises applying radio frequency power to the radio frequency coil (7), optionally wherein the radio frequency power is about 0.5 megahertz to about 10.0 megahertz, optionally and/ or wherein the oxidizing the remaining portion of the first material deposited in the sputtering apparatus (SA) further comprises non-application of bias power to the stage (3).

5. The method of any one of claims 1 to 4, wherein the removing the portion of the first material deposited in the sputtering apparatus (SA) comprises supplying an argon gas to the plasma discharge space (5h).

6. The method of any one of claims 1 to 5, wherein oxidizing the remaining portion of the first material deposited in the sputtering apparatus (SA) further comprises placing a dummy substrate on the stage (3).

7. A sputtering method comprising:
etching a substrate (SB) using a sputtering apparatus (SA);
removing the substrate from the sputtering apparatus; and
cleaning the sputtering apparatus from which the substrate is removed
wherein cleaning the sputtering apparatus (SA) comprises performing a method in accordance with any one of claims to 9.

8. The sputtering method of claim 7, wherein the etching the substrate (SB) using the sputtering apparatus (SA) comprises removing copper in the substrate to etch the substrate,
wherein the first material comprises copper, optionally wherein the etching the substrate (SB) using the sputtering apparatus (SA) comprises supplying an argon gas to the plasma discharge space (5h).

9. The sputtering method of claim 7 or 8, wherein the etching the substrate (SB) using the sputtering apparatus (SA) comprises applying first radio frequency power to the radio frequency coil (7), and
the oxidizing the first material deposited in the sputtering apparatus comprises applying second radio frequency power to the radio frequency coil (7),
wherein a frequency of the second radio frequency power is less than a frequency of the first radio frequency power.

10. The sputtering method of claim 7, 8 or 9, wherein the etching the substrate (SB) using the sputtering apparatus (SA) comprises applying bias power to the stage,
the oxidizing the first material deposited in the sputtering apparatus comprises non-application of the bias power to the stage (3).

11. The sputtering method of any one of claims 7 to 10, wherein a temperature of the discharge tube (5) in the oxidizing the first material deposited in the sputtering apparatus (SA) is higher than a temperature of the discharge tube in the etching the substrate (SB) using the sputtering apparatus.

12. The sputtering method of any one of claims 7 to 11, wherein the oxidizing the first material deposited in the sputtering apparatus (SA) comprises placing a dummy substrate (DSB) on the stage (3) from which the substrate (SB) is removed.

13. A sputtering system comprising:
a sputtering apparatus (SA);
a process gas supply device (41) which supplies a process gas to the sputtering apparatus; and
an oxygen gas supply device (43) which supplies an oxygen gas to the sputtering apparatus,
wherein the sputtering apparatus (SA) comprises:
a process chamber (1) which provides a process space (1h);
a stage (3) within the process space;
a discharge tube (5) which provides a plasma discharge space (5h) extended to
the process space (1h);
a radio frequency coil (7) which wraps the discharge tube; and
a heating device (8) which heats the discharge tube.

14. The sputtering system of claim 13, wherein the heating device (8) comprises at least one of:
an IR heating device which irradiates IR into the plasma discharge space;
a heating module connected to one end of the discharge tube (5); or
a heating line coupled to the discharge tube.

15. The sputtering system of claim 13 or 14, wherein the process gas supply device (41) supplies an argon gas to the plasma discharge space (5h).
